# EUROPEAN PATENT APPLICATION

(11) **EP 3 939 885 A2**
(43) Date of publication of application: **19.01.2022**
(21) Application number: 21186496.2
(22) Date of filing: 19.07.2021
(51) Int. Cl.: B64D 11/00, G06F 3/01

(54) **TOUCHLESS PASSENGER SERVICE UNIT**

(30) Priority: 18.07.2020 IN 202041030648; 28.12.2020 US 202017135241
(71) Applicant: Goodrich Corporation, Charlotte, NC 28217-4578 (US)
(72) Inventor: PALANIAPPAN, Elangovan, 560049 Bangalore, KA (IN); AGARWAL, Ashish Kumar, 560049 Bengaluru, Karnataka (IN)
(74) Representative: Dehns

(57) **Abstract**

A passenger service unit for use in an aircraft cabin includes an output device (104, 108, 118) configured to output information in the aircraft cabin. The passenger service unit further includes a touchless sensor (102, 106, 116) configured to detect a presence of an object in a vicinity of the touchless sensor, and to output a signal for controlling the output device in response to detecting the presence of the object.

## Description

### CROSS-REFERENCE TO RELATED APPLICATIONS

This application is a non-provisional of, and claims priority to, and the benefit of India Provisional Application No. 202041030651 with DAS Code 5E1A, entitled "TOUCHLESS PASSENGER SERVICE UNIT," filed on July 18, 2020.

### FIELD

The present disclosure relates to passenger service units for aircraft and, in particular, touchless passenger service units.

### BACKGROUND

Aircraft cabins may include passenger service units (PSUs) which include output devices. For example, the PSUs may include output devices such as reading lights, flight attendant call devices, and fans for blowing air towards a passenger or flight attendant. Such output devices are conventionally controlled by a manual button installed on the PSU. However, such buttons may exacerbate the spread of pathogens. For example, if a sick passenger sneezes or coughs into his or her hand and then touches the button, the pathogens remain on the button. If the next passenger touches the same button and then touches his or her face, he or she may become sick with the same pathogen as the original passenger.

### SUMMARY

Disclosed herein is a passenger service unit for use in an aircraft cabin. The passenger service unit includes an output device configured to output information in the aircraft cabin. The passenger service unit further includes a touchless sensor configured to detect a presence of an object in a vicinity of the touchless sensor, and to output a signal for controlling the output device in response to detecting the presence of the object.

Any of the foregoing embodiments may further include a driver coupled to the touchless sensor and configured to facilitate at least one of a current or a voltage for powering the output device based on the signal.

Any of the foregoing embodiments may further include a controller coupled to the touchless sensor and the driver and configured to: receive a first signal from the touchless sensor corresponding to a first detected presence of the object and receive a second signal from the touchless sensor corresponding to a second detected presence of the object; output a first control signal to the driver in response to receiving the first signal from the touchless sensor, the first control signal configured to cause the driver to provide power to the output device; and output a second control signal to the driver in response to receiving the second signal from the touchless sensor, the second control signal configured to cause the driver to cease providing power to the output device.

In any of the foregoing embodiments, at least one of the first signal or the second signal includes at least one of zero volts or zero amps.

Any of the foregoing embodiments may further include a low-dropout regulator coupled between the touchless sensor and the output device, configured to regulate a power signal provided to the output device.

Any of the foregoing embodiments may further include a power source coupled to the output device, wherein the driver is configured to allow current to flow from the power source through the output device in response to receiving the first signal, and to prevent current from flowing through the output device in response to receiving the second signal.

In any of the foregoing embodiments, the driver includes a static switch.

In any of the foregoing embodiments, the touchless sensor includes at least one of a wireless signal detector or a motion detector sensor.

Any of the foregoing embodiments may further include a housing defining a cutout, wherein the touchless sensor is configured to detect the presence of the object in response to the object being located in the cutout.

In any of the foregoing embodiments, the output device includes at least one of a reading light, an attendant call device, or a fan.

Also disclosed is a system for controlling a passenger service unit. The system includes a remote controller having: an input device configured to receive user input corresponding to a request to activate an output device of the passenger service unit, the output device including at least one of a reading light, an attendant call device, or a fan, and a transmitter configured to transmit a wireless signal in response to the input device receiving the request. The system further includes the passenger service unit having: a receiver configured to receive the wireless signal and to output a control signal in response to receiving the wireless signal, and the output device configured to output light in response to receiving the control signal.

In any of the foregoing embodiments, the passenger service unit further includes a decoder configured to receive the wireless signal from the receiver and to output the control signal in response to receiving the wireless signal.

In any of the foregoing embodiments, the passenger service unit further includes a power supply configured to provide electrical power to the output device.

In any of the foregoing embodiments, the passenger service unit further includes an antenna configured to receive the wireless signal and to transmit the wireless signal to the receiver.

In any of the foregoing embodiments, the output device further includes a driver configured to facilitate a current flow from the power supply through the output device in response to receiving the control signal from the decoder.

Also disclosed is a method for touchless control of a passenger service unit of an aircraft cabin. The method includes detecting, by a touchless sensor, a presence of an object in a vicinity of the touchless sensor. The method further includes outputting, by the touchless sensor, a signal for controlling an output device in response to detecting the presence of the object.

Any of the foregoing embodiments may further include facilitating, by a driver, at least one of a current or a voltage for powering the output device based on the signal.

Any of the foregoing embodiments may further include receiving, by a controller, a first signal from the touchless sensor corresponding to a first detected presence of the object; receiving, by the controller, a second signal from the touchless sensor corresponding to a second detected presence of the object; outputting, by the controller, a first control signal to the driver in response to receiving the first signal from the touchless sensor, the first control signal configured to cause the driver to provide power to the output device; and outputting, by the controller, a second control signal to the driver in response to receiving the second signal from the touchless sensor, the second control signal configured to cause the driver to cease providing power to the output device.

In any of the foregoing embodiments, at least one of the first signal or the second signal includes at least one of zero volts or zero amps.

Any of the foregoing embodiments may further include regulating, by a low-dropout regulator, a power signal provided to the output device.

The foregoing features and elements may be combined in various combinations without exclusivity, unless expressly indicated otherwise. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the figures, wherein like numerals denote like elements.
FIG. 1 illustrates a passenger service unit (PSU) designed to be operated in a touchless fashion, in accordance with various embodiments;
FIG. 2 illustrates additional details of the PSU of FIG. 1, in accordance with various embodiments;
FIG. 3 illustrates additional details of the PSU of FIG. 1, in accordance with various embodiments;
FIG. 4 illustrates a method for controlling a PSU in a touchless fashion, in accordance with various embodiments;
FIG. 5 illustrates a system for wireless control of a PSU, in accordance with various embodiments;
FIG. 6 illustrates additional details of the system of FIG. 5, in accordance with various embodiments; and
FIG. 7 illustrates a method for wireless control of a PSU, in accordance with various embodiments.

### DETAILED DESCRIPTION

The detailed description of exemplary embodiments herein makes reference to the accompanying drawings, which show exemplary embodiments by way of illustration. While these exemplary embodiments are described in sufficient detail to enable those skilled in the art to practice the exemplary embodiments of the disclosure, it should be understood that other embodiments may be realized and that logical changes and adaptations in design and construction may be made in accordance with this disclosure and the teachings herein. Thus, the detailed description herein is presented for purposes of illustration only and not limitation. The steps recited in any of the method or process descriptions may be executed in any order and are not necessarily limited to the order presented.

Furthermore, any reference to singular includes plural embodiments, and any reference to more than one component or step may include a singular embodiment or step. Also, any reference to attached, fixed, connected or the like may include permanent, removable, temporary, partial, full and/or any other possible attachment option. Additionally, any reference to without contact (or similar phrases) may also include reduced contact or minimal contact. Surface shading lines may be used throughout the figures to denote different parts but not necessarily to denote the same or different materials.

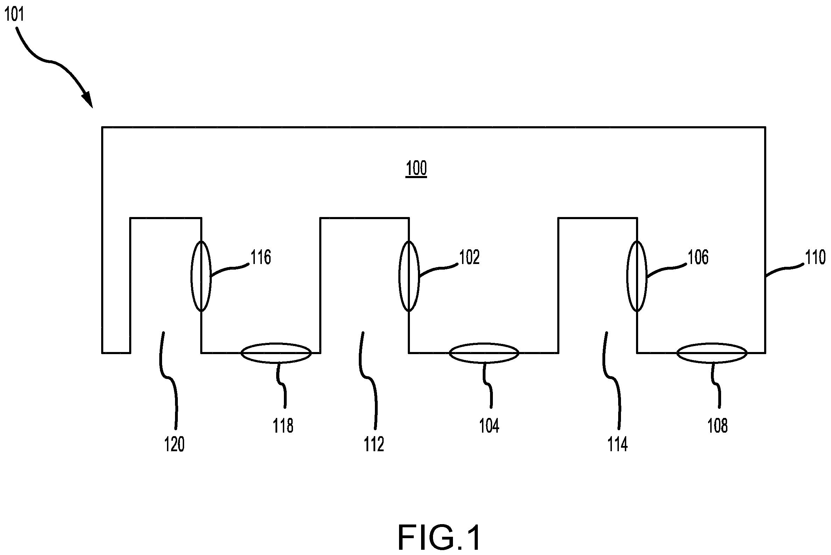

Referring now to FIG. 1, a touchless passenger service unit (PSU) 100 for use in an aircraft cabin 101 is shown. The PSU 100 may include or be coupled to various output devices designed to be controlled in a touchless manner. For example, the PSU 100 may include a reading light 104, an attendant call device 108, and a fan 118. The reading light 104 may include a light-emitting diode (LED) or any other light emitting device. The attendant call device 108 may include a light-emitting device, a speaker, or any other output device designed to bring attention to the fact that a passenger requires assistance. The fan 118 may include any fan, blower, or the like capable of directing air towards a seat in the aircraft cabin 101.

The PSU 100 may further include touchless sensors designed to detect the presence of an object in their vicinity. For example, the PSU 100 may include a first touchless sensor 102 designed to control operation of the reading light 104, a second touchless sensor 106 designed to control operation of the attendant call device 108, and a third touchless sensor 116 designed to control operation of the fan 118. The touchless sensors 102, 106, 116 may include any sensor capable of detecting the presence of an object, such as a human hand or finger, within a vicinity of the sensor. For example, the touchless sensors 102, 106, 116 may include at least one of a wireless signal detector or a motion detector sensor (e.g., one or more of a passive infrared (PIR) sensor, a proximity sensor, a light detector, a camera, or the like).

The touchless sensors 102, 106, 116 may output a signal in response to detecting the presence of the object, and the signal may be received by the corresponding output device to control operation of the output device. For example, in response to a first detection of an object by the touchless sensor 102, the reading light 104 may become illuminated. In response to a second detection of the object by the touchless sensor 102, the reading light 104 may be turned off.

The PSU 100 may include a housing 110 that defines multiple cutouts 112, 114, 120, and the touchless sensors 102, 106, 116 may be oriented in such a manner that they detect the presence of objects within the cutouts 112, 114, 120. For example, the touchless sensor 102 may detect the presence of a human finger in response to the human finger being located within the cutout 112. The illustration of the PSU 100 of FIG. 1 illustrates a cross-sectional view of the housing 110 looking in a forward direction from an aft end of an aircraft. Use of the cutouts 112, 114, 120 reduce the likelihood of an accidental activation of the output devices.

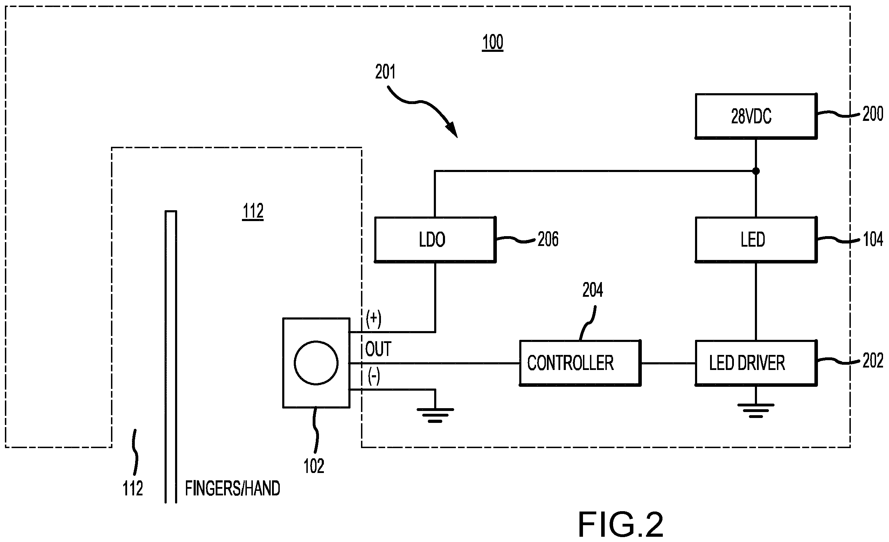

Turning now to FIG. 2, additional details of the PSU 100 are shown. In particular, the PSU 100 may include a system 201 for controlling operation of the reading light 104 based on data detected by the touchless sensor 102. In various embodiments, each of the output devices of the PSU 100 may include separate control systems such as the system 201.

The system 201 may include a power source 200, a driver 202, a controller 204, and a low dropout regulator (LDO) 206.

The power source 200 is designed to output at least one of a voltage or a current for powering the reading light 104. The driver 202 is designed to facilitate current flow through the reading light 104 or a voltage applied to the reading light 104. The LDO 206 is coupled between the reading light 104 and the touchless sensor 102 and is configured to regulate a power signal provided to the reading light 104. The controller 204 is designed to control operation of the reading light 104 based on a signal output by the touchless sensor 102.

In response to a first detection of an object by the touchless sensor 102, the touchless sensor 102 may output a first signal that is received by the controller 204. In response to receiving the first signal, the controller 204 may output a first control signal to the driver 202. The first control signal is designed to cause the driver 202 to facilitate current flow through the reading light 104 in order to power on the reading light 104. The controller 204 may continue outputting the first control signal even if the object is removed from the cutout 112.

In response to a second detection of the object by the touchless sensor 102, the touchless sensor 102 may output a second signal that is received by the controller 204. In response to receiving a second signal, the controller 204 may output a second control signal to the driver 202. In various embodiments, the second control signal may be a logical "0," or a lack of a signal. The second control signal is designed to cause the driver 202 to reduce the likelihood of current flow through the reading light 104 in order to power down the reading light 104. The controller 204 may continue outputting the second control signal even if the object is removed from the cutout 112.

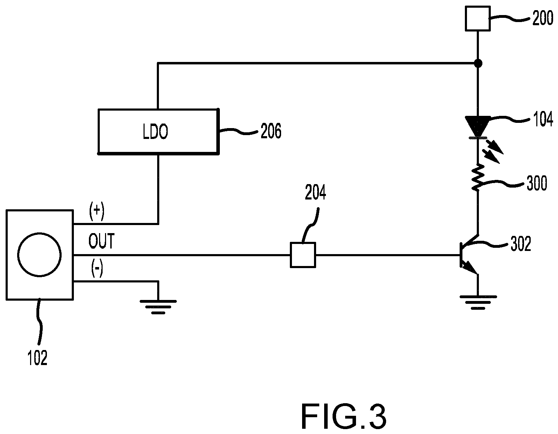

Referring now to FIG. 3 and in various embodiments, the driver 202 of FIG. 2 may include a static switch such as a transistor 302 (e.g., a bipolar junction transistor (BJT) 302). In response to receiving a logical "1" at the gate of the transistor 302, the transistor 302 may become "closed," allowing current to flow through the transistor 302 and, thus, the LED 104 (turning the LED 104 on). In response to receiving a logical "0" at the gate of the transistor 302, the transistor 302 may become "open," reducing the likelihood of current flowing through the transistor 302 and, thus, the LED 104 (turning the LED 104 off). A resistor 300 may be added in series with the LED 104 in order to regulate current flowing through the LED 104.

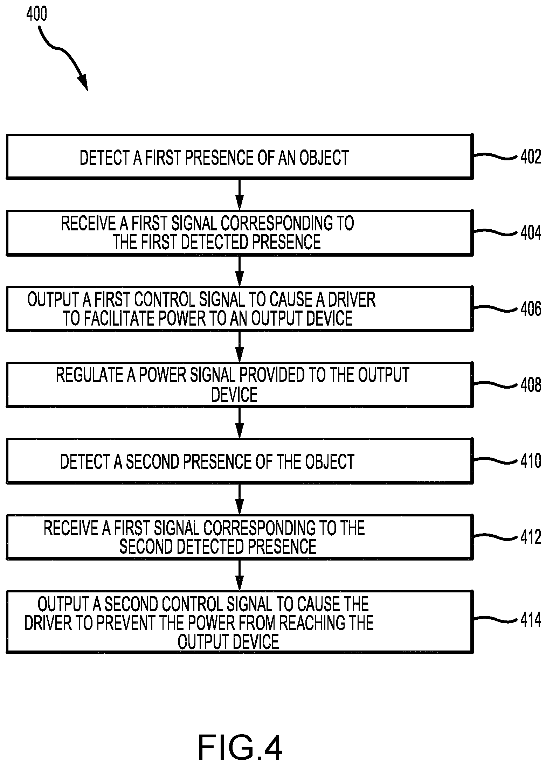

Referring now to FIG. 4, a method 400 for touchless control of a PSU of an aircraft cabin, such as the PSU 100 of FIG. 1, is shown. The method begins in block 402 where a touchless sensor may detect a first presence of an object. In block 404, a controller may receive a first signal corresponding to the first detected presence in block 402. In block 406, the controller may output a first control signal to cause a driver to facilitate power to an output device, such as a light source or speaker (turning the output device on). Simultaneously and in block 408, a regulator may regulate a power signal provided to the output device.

In block 410, the touchless sensor may detect a second presence of the object. In block 412, the controller may receive second first control signal corresponding to the second active presence. In block 414, the controller may output a second control signal to cause the driver to prevent the power from reaching the output device (turning the output device off).

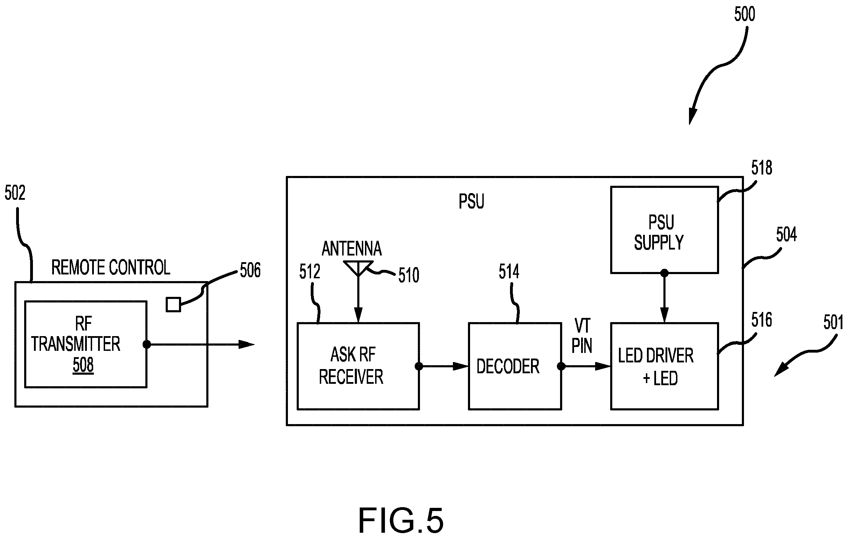

Referring now to FIG. 5, a system 500 for controlling a PSU of an aircraft cabin 501 is shown. The system 500 may include a remote controller 502 and a PSU 504. The remote controller 502 may be a standalone remote controller for the PSU 504 or may also be designed to operate other components of the aircraft cabin (e.g., a seatback display).

The remote controller 502 may include an input device 506 designed to receive user input corresponding to a request to control an output device of the PSU 504. For example, the input device 506 may include a button, a knob, a dial, a touchscreen, or the like. The remote controller 502 may further include a transmitter 508 designed to transmit a signal. In response to the input device 506 receiving a request for controlling the PSU 504, the transmitter 508 may transmit the signal. For example, a user may depress the input device 506 a first time to turn on a light of the PSU 504, and made depress the input device 506 a second time to turn off the light of the PSU 504.

The PSU 504 may include an antenna 510, a receiver 512, a decoder 514, an output device with driver 516, and a power supply 518. The antenna 510 may be designed to receive the signal, such as a wireless signal (e.g., infrared, radio frequency, Bluetooth, Zigbee, LoRa, WiFi, near-field communications, etc.), transmitted by the transmitter 508 of the remote control 502. The receiver 512 may be coupled to the antenna 510 and may receive the signal from the antenna 510. The decoder 514 may receive the signal from the receiver 512 and may output a control signal for controlling the output device and driver 516 in response to receiving the signal. The driver of the output device and driver 516 may control power flow to the output device, and the output device may output information (e.g., light, airflow, sound, or the like) to a user of the aircraft cabin 501. The power supply 518 may provide a current or voltage signal for powering the output device.

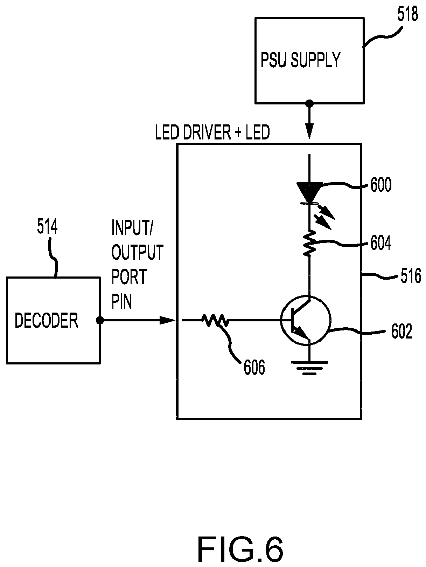

Referring now to FIG. 6, additional details of the output device and driver 516 are shown. In particular, a resistor 606 may receive the control signal from the decoder 514, and the output device 600 may be coupled to the power supply 518 in series with a second resistor 604. In various embodiments, the driver may include a transistor 602, such as a BJT, MOSFET, IGBT, or the like. In response to a logical "1" applied to the gate of the transistor 602, the transistor 602 may become closed, allowing current to flow through the output device 600 (turning the output device 600 on). In response to a logical "0" applied to the gate of the transistor 602, the transistor 602 may become open, reducing the likelihood of current flowing through the output device 600 (turning the output device 600 off).

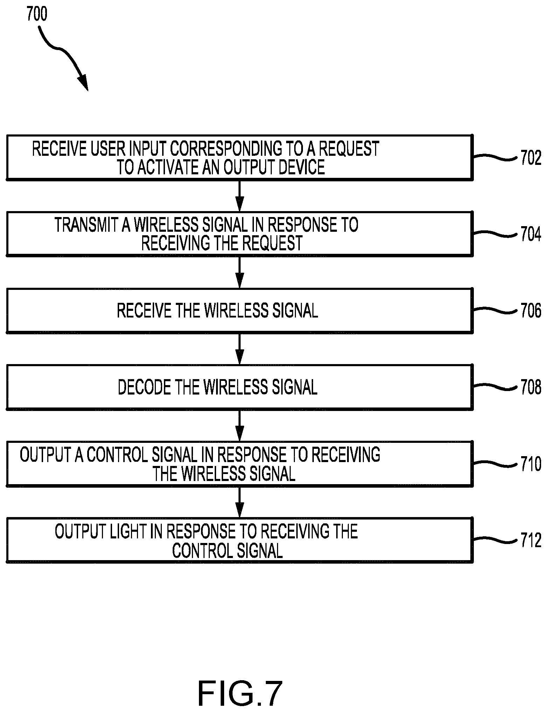

Referring now to FIG. 7, a method 700 for controlling operation of a system, such as the system 500 of FIG. 5, is shown. The method 700 may begin in block 702 in which a remote controller may receive user input corresponding to a request to activate an output device of the PSU. In block 704, a transmitter of the remote controller may transmit a wireless signal (e.g., infrared, radio frequency, Bluetooth, Zigbee, LoRa, WiFi, near-field communications, etc.) in response to receiving the request. In block 706, an antenna and receiver may receive the wireless signal from the remote controller. In block 708, a decoder may decode the wireless signal. In block 710, the decoder may output a control signal in response to receiving the decoded wireless signal. In block 712, a driver of the output device may control an amount of power provided to the output device to cause the output device to output information into the aircraft cabin.

Benefits and other advantages have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, and any elements that may cause any benefit or advantage to occur or become more pronounced are not to be construed as critical, required, or essential features or elements of the disclosure. The scope of the disclosure is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C.

Systems, methods and apparatus are provided herein. In the detailed description herein, references to "various embodiments", "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

## Claims

1. A passenger service unit (100) for use in an aircraft cabin (101), the passenger service unit comprising:
an output device (104, 108, 118) configured to output information in the aircraft cabin; and
a touchless sensor (102, 106, 116) configured to detect a presence of an object in a vicinity of the touchless sensor, and to output a signal for controlling the output device in response to detecting the presence of the object.

2. The passenger service unit of claim 1, further comprising a driver (202) coupled to the touchless sensor and configured to facilitate at least one of a current or a voltage for powering the output device based on the signal.

3. The passenger service unit of claim 2, further comprising a controller (204) coupled to the touchless sensor and the driver and configured to:
receive a first signal from the touchless sensor corresponding to a first detected presence of the object and receive a second signal from the touchless sensor corresponding to a second detected presence of the object;
output a first control signal to the driver in response to receiving the first signal from the touchless sensor, the first control signal configured to cause the driver to provide power to the output device; and
output a second control signal to the driver in response to receiving the second signal from the touchless sensor, the second control signal configured to cause the driver to cease providing power to the output device.

4. The passenger service unit of claim 3, wherein at least one of the first signal or the second signal includes at least one of zero volts or zero amps.

5. The passenger service unit of claim 3, further comprising a low-dropout regulator (206) coupled between the touchless sensor and the output device, configured to regulate a power signal provided to the output device.

6. The passenger service unit of claim 5, further comprising a power source (200) coupled to the output device, wherein the driver is configured to allow current to flow from the power source through the output device in response to receiving the first signal, and to prevent current from flowing through the output device in response to receiving the second signal.

7. The passenger service unit of claim 6, wherein the driver includes a static switch (302), and optionally wherein the touchless sensor includes at least one of a wireless signal detector or a motion detector sensor.

8. The passenger service unit of any preceding claim, further comprising a housing (110) defining a cutout, wherein the touchless sensor is configured to detect the presence of the object in response to the object being located in the cutout.

9. The passenger service unit of any preceding claim, wherein the output device includes at least one of a reading light (104), an attendant call device (108), or a fan (118).

10. A system for controlling a passenger service unit, the system comprising:
a remote controller (502) having:
an input device (506) configured to receive user input corresponding to a request to activate an output device of the passenger service unit, the output device including at least one of a reading light, an attendant call device, or a fan, and
a transmitter (508) configured to transmit a wireless signal in response to the input device receiving the request; and
the passenger service unit having:
a receiver (512) configured to receive the wireless signal and to output a control signal in response to receiving the wireless signal, and
the output device configured to output light in response to receiving the control signal.

11. The system of claim 10, wherein the passenger service unit further includes a decoder configured to receive the wireless signal from the receiver and to output the control signal in response to receiving the wireless signal, and optionally wherein the passenger service unit further includes a power supply (518) configured to provide electrical power to the output device, and further optionally wherein the passenger service unit further includes an antenna (510) configured to receive the wireless signal and to transmit the wireless signal to the receiver, and optionally wherein the output device further includes a driver (516) configured to facilitate a current flow from the power supply through the output device in response to receiving the control signal from the decoder.

12. A method for touchless control of a passenger service unit of an aircraft cabin, the method comprising:
detecting, by a touchless sensor (102, 106, 116), a presence of an object in a vicinity of the touchless sensor; and
outputting, by the touchless sensor, a signal for controlling an output device (104, 108, 118) in response to detecting the presence of the object.

13. The method of claim 12, further comprising facilitating, by a driver (202), at least one of a current or a voltage for powering the output device based on the signal.

14. The method of claim 13, further comprising:
receiving, by a controller (204), a first signal from the touchless sensor corresponding to a first detected presence of the object;
receiving, by the controller, a second signal from the touchless sensor corresponding to a second detected presence of the object;
outputting, by the controller, a first control signal to the driver in response to receiving the first signal from the touchless sensor, the first control signal configured to cause the driver to provide power to the output device; and
outputting, by the controller, a second control signal to the driver in response to receiving the second signal from the touchless sensor, the second control signal configured to cause the driver to cease providing power to the output device.

15. The method of claim 14, wherein at least one of the first signal or the second signal includes at least one of zero volts or zero amps, and/or further comprising regulating, by a low-dropout regulator (206), a power signal provided to the output device.
